**Europäisches Patentamt**

**European Patent Office**

**Office européen des brevets**

(19)

(11) Veröffentlichungsnummer : **0 410 277 B1**

# EUROPÄISCHE PATENTSCHRIFT

(12)

(45) Veröffentlichungstag der Patentschrift :
**04.10.95 Patentblatt 95/40**

(51) Int. Cl.⁶ : **G03F 7/004**

(21) Anmeldenummer : **90113711.7**

(22) Anmeldetag : **18.07.90**

(54) Beschichtungslösung für die Herstellung negativ arbeitender lichtempfindlicher Aufzeichnungsmaterialen.

(30) Priorität : **27.07.89 DE 3924812**

(43) Veröffentlichungstag der Anmeldung :
**30.01.91 Patentblatt 91/05**

(45) Bekanntmachung des Hinweises auf die Patenterteilung :
**04.10.95 Patentblatt 95/40**

(84) Benannte Vertragsstaaten :
**DE FR GB IT NL**

(56) Entgegenhaltungen :
**EP-A- 0 089 506**
**DD-A- 96 345**
**DE-A- 3 627 585**
**DE-A- 3 705 342**
**GB-A- 2 021 276**

(73) Patentinhaber : **HOECHST AKTIENGESELLSCHAFT**
**D-65926 Frankfurt am Main (DE)**

(72) Erfinder : **Arneth, Reinhold, Dr.**
**Alicestrasse 19**
**D-6501 Budenheim (DE)**
Erfinder : **Hehl, Eberhard**
**Hammergasse 84**
**D-6507 Ingelheim (DE)**
Erfinder : **Frass, Werner, Dr.**
**Erbsenacker 37**
**D-6200 Wiesbaden (DE)**
Erfinder : **Jung, Günter**
**Zum Schwimmbad 5**
**D-6204 Taunusstein-Hahn (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft Lösemittelgemische, die für die Herstellung negativ arbeitender lichtempfindlicher Aufzeichnungsmaterialien, insbesondere solcher, die ein Diazoniumsalz-Polykondensationsprodukt und ein polymeres Bindemittel enthalten, vor allem für die Herstellung von Druckplatten, geeignet sind.

Zur Herstellung von Druckplatten wird das benötigte lichtempfindliche Gemisch in entsprechenden verträglichen Lösemitteln gelöst und das Trägermaterial mit der Lösung beschichtet und anschließend zur Schicht getrocknet.

In der EP-A 0 048 876 (= US-A 4 387 151) sind negativ arbeitende, lichtempfindliche Zusammensetzungen, die ein Diazoniumsalz-Polykondensationsprodukt oder eine Azidoverbindung und als Bindemittel ein hochmolekulares Polymeres mit seitenständigen Sulfonylurethangruppen enthalten, beschrieben. Für diese negativ arbeitenden, lichtempfindlichen Zusammensetzungen werden als Lösemittel Alkohole, Ketone, Ester und Ether, bevorzugt Partialether der Glykole oder Ketoalkohole, angegeben, wobei in den Beispielen Ethylenglykolmonomethylether, gegebenenfalls in Kombination mit Tetrahydrofuran bzw. Butylacetat verwendet wird. Als weitere Lösemittel sind Ethylenglykolmonoethylether, Aceconalkohol sowie Gemische der Lösemittel mit Butylacetat, Ethylenglykolmethyletheracetat und Methylisobutylketon erwähnt.

Viele dieser Lösemittel zeigen zwar ein gutes Lösungsvermögen für die negativ arbeitenden lichtempfindlichen Zusammensetzungen, jedoch liegen ihre MAK-Werte (Maximale Arbeitsplatzkonzentrationen und Biologische Arbeitsstofftoleranzwerte) sehr niedrig (Ethylenglykolmonomethylether MAK 5 ml/m$^3$; Ethylenglykolmonoethylether MAK 20 ml/m$^3$), wodurch bei deren Verwendung am Arbeitsplatz besonders aufwendige Sicherheitsvorkehrungen zu treffen sind.

Die EP-A 0 164 083 (= US-A 4 764 450) beschreibt Lösemittel für positiv arbeitende strahlungsempfindliche Gemische, die als wesentliche Verbindung z. B. ein 1,2-Naphthochinondiazid oder eine strahlungsempfindliche Kombination von Verbindungen - z. B. eine mit mindestens einer durch Säure spaltbaren C-O-C-Bindung und eine bei Bestrahlung eine starke Säure bildende Verbindung - enthalten. Das verwendete Lösemittel enthält dabei im wesentlichen einen Mono-C$_1$- bis C$_4$-Alkylether des 1,2-Propandiols.

In der DE-A 36 27 585 wird ein Verfahren zur Herstellung einer vorsensibilisierten Flachdruckform beschrieben, bei dem eine Aluminiumplatte mit einer Lösung beschichtet wird, deren Lösemittel mindestens 10 Gew.-% 1-Methoxy-2-propanol enthält. Als weitere Lösemittelbestandteile werden Ketone, Ester, cyclische Ether wie Tetrahydrofuran, Alkohole, halogenierte Kohlenwasserstoffe, Dimethylformamid, Butyrolacton und andere eingesetzt. Das Methoxypropanol soll eine geringere Neigung der Druckform zum Tonen bewirken, die übrigen Lösemittel haben keine besondere Wirkung und sind austauschbar.

In der DE-A 37 05 342 wird eine Beschichtungslösung zur Herstellung positiv arbeitender lichtempfindlicher Aufzeichnungsmaterialien beschrieben, die als Lösemittel ein Gemisch aus drei Komponenten mit unterschiedlichem Siedepunkt enthält. Das Gemisch erlaubt eine rasche kontinuierliche Trocknung der Lösung zu einer Schicht mit hoher Entwicklerresistenz, mechanischer Festigkeit und Oleophilie. Als Lösemittelbestandteile werden Ketone, Ester, Glykolmonoalkylether und Halogenalkane eingesetzt.

Als häufigster Lösemittelbestandteil für lichtempfindliche Gemische auf Basis von negativ arbeitenden Diazoniumsalz-Polykondensationsprodukten und polymeren Bindemitteln wurden bisher Glykolether, insbesondere 2-Methoxyethanol eingesetzt. Da jedoch in neuerer Zeit gesundheitsschädigende Wirkungen dieses bisher bevorzugten Lösemittels bekannt geworden sind und als Folge davon die MAK-Werte drastisch herabgesetzt wurden, ist es erforderlich, dieses Lösemittel durch andere weniger schädliche zu ersetzen. Man hat deshalb auf die im Stand der Technik beschriebenen homologen Propylenglykolether zurückgegriffen, die in höheren Dosen zulässig sind. Allerdings sind diese Ether zumeist nicht in der Lage, Diazoniumsalz-Polykondensationsprodukte als einzige Lösemittel zu lösen. Es wurden deshalb Gemische mit Ketonen, Estern, Alkoholen, Wasser u. a. eingesetzt, die ein ausreichendes Lösevermögen aufweisen.

Bei der Bearbeitung solcher Probleme wurde nun gefunden, daß lichtempfindliche Schichten auf Basis von Diazoniumsalz-Polykondensationsprodukten, die aus solchen Lösemittelgemischen hergestellt worden sind, in der Regel eine um 1 bis 2 Keilstufen, also um den Faktor 1,4 bis 2, geringere Lichtempfindlichkeit aufweisen als Schichten der gleichen Zusammensetzung, die aus 2-Methoxy-ethanol als einzigem oder Hauptlösemittel beschichtet worden sind. Auch weisen diese Schichten eine flachere Gradation auf.

Aufgabe der Erfindung war es, eine Beschichtungslösung für die Herstellung lichtempfindlicher Aufzeichnungsmaterialien, besonders Druckplatten, vorzuschlagen, die keinen Abfall der Lichtempfindlichkeit und keine Verflachung der Gradation der damit erhaltenen Schichten gegenüber solchen Materialien ergibt, wie sie bisher mit den besten bekannten Beschichtungslösemitteln erhalten wurden.

Erfindungsgemäß wird eine Beschichtungslösung zur Herstellung von lichthärtbaren Aufzeichnungsmaterialien vorgeschlagen, die als wesentliche Bestandteile eine lichthärtbare Verbindung, ein polymeres Bindemittel und ein Lösemittelgemisch enthält.

Das Lösungsmittelgemisch ist ein Gemisch aus

a) einem Gemisch aus

    aa) einem polaren Lösemittel der Formel

$$R - OH,$$

    worin R eine Alkylgruppe mit 1 bis 3 Kohlenstoffatomen ist, oder

    aa') einem Monoalkylether oder einem Alkyletherester des Propylenglykols,

    ab) einem organischen Lösemittel mit einem Siedepunkt im Bereich von 60 bis 160 °C, das ein aliphatisches Keton, ein Alkansäure- oder Hydroxyalkansäurealkylester oder ein cyclischer Ether ist, und

    ac) einem organischen Lösemittel mit einem Siedepunkt im Bereich von 120 bis 180 °C, das ein Monoalkylether oder ein Alkyletherester des Propylenglykols oder ein Alkylester einer Hydroxyalkansäure ist mit der Maßgabe, daß (ac) kein Ether oder Etherester des Propylenglykols ist, wenn (aa') vorhanden ist, und daß (ac) kein Alkylester einer Hydroxyalkansäure ist, wenn (ab) diese Bedeutung hat,

in solchem Mengenverhältnis, daß ein homogenes Gemisch gebildet wird, und

b) 0,1 bis 8 Gew.-%, bezogen auf das gesamte Lösemittelgemisch, eines Lösemittels, dessen Siedepunkt höher liegt als jeder einzelne Siedepunkt der unter (a) genannten Lösemittel, und das ein Lacton, ein cyclischer Ester, der kein Lacton ist, ein Sulfoxid, ein Diglykolether oder ein Lactam ist.

Durch den erfindungsgemäßen Zusatz des hochsiedenden Lösemittels (b) wird erreicht, daß mit den Lösemittelgemischen auf Basis von Propylenglykolethern Schichten mindestens gleicher Lichtempfindlichkeit erhalten werden wie mit Lösemitteln auf Basis von Ethylenglykolethern.

Das erfindungsgemäße Lösemittelgemisch enthält einen relativ niedrigsiedenden Anteil (a), der als polares Lösemittel (aa) einen niederen aliphatischen Alkohol, wie Methanol, Ethanol, n-Propanol oder Isopropanol enthält. Das Gemisch enthält ferner eine Komponente (ab) mit einem Siedepunkt im Bereich von 60 bis 160 °C, die insbesondere ein Keton mit 3 bis 6 Kohlenstoffatomen, z. B. Aceton, Butanon, Pentanon oder Methylisobutylketon; ein Ester einer Alkan- oder Hydroxyalkansäure mit vorzugsweise 2 bis 5 Kohlenstoffatomen, z. B. Essig-, Propion-, Butter-, Glykol- oder Milchsäure, mit einem Alkanol mit 1 bis 4 Kohlenstoffatomen; oder ein gesättigter cyclischer Ether, z. B. Tetrahydrofuran, Tetrahydropyran oder 1,4-Dioxan ist. Der Ester hat insgesamt 3 bis 8, bevorzugt 4 bis 6 Kohlenstoffatome.

Das Gemisch enthält ferner einen Anteil eines Lösemittels (b), das höher siedet als die Bestandteile von (a), insbesondere mit einem Siedepunkt im Bereich von 160 - 300, vorzugsweise von 160 - 250, insbesondere 185 - 250 °C. Dieses Lösemittel kann ein Lacton, wie Butyrolacton oder Valerolacton, oder ein anderer cyclischer Ester wie Ethylencarbonat oder Propylencarbonat, ein Sulfoxid wie Dimethylsulfoxid oder Diethylsulfoxid, ein Diglykolether, z. B. Diethylenglykoldimethylether oder Diethylenglykolmonoethylether oder ein Lactam wie N-Methyl- oder N-Ethyl-pyrrolidon sein.

Das Gemisch enthält noch einen weiteren Bestandteil (ac), der einen Siedepunkt im Bereich von 120 bis 180 °C hat und ein Monoalkylether oder ein Alkyletherester von Propylenglykol ist, in dem die Alkylgruppen 1 bis 4, bevorzugt 1 oder 2 und die Acylgruppe 2 bis 4 Kohlenstoffatome haben können.

Die Komponente (aa) ist vorzugsweise Methanol.

Das Lösemittel (b) liegt in dem Gemisch in einem Mengenanteil von 0,1 bis 8, vorzugsweise von 0,1 bis 4,5 Gew.-% vor. Insbesondere bei Vertretern dieser Lösemittel, die im oberen Teil des angegebenen Bereichs sieden, ist es vorteilhaft, weniger als 4,5 Gew.-% zuzusetzen.

Das Gemisch (a) besteht entweder aus (aa) und (ab) oder aus (aa') und (ab) und zusätzlich (ac). In jedem Falle kann eine Komponente auch ein Gemisch aus zwei oder mehreren Vertretern derselben Komponente sein.

Die polare Komponente (aa) liegt im allgemeinen in einem Mengenanteil von 0 bis 70, vorzugsweise von 5 bis 60 Gew.-%, bezogen auf das gesamte Lösemittelgemisch, vor. Wenn (aa) Ethanol ist, ist es in einem Anteil von mindestens 25 % enthalten. Methanol, das als Komponente (aa) bevorzugt wird, hat im allgemeinen einen Mengenanteil von 10 bis 55, insbesondere von 15 bis 50 Gew.-%.

Die Komponente (ab), die in dem Gemisch (a) immer vorhanden ist, hat im allgemeinen einen Mengenanteil von 3 bis 70, bevorzugt von 5 bis 60 Gew.-%.

Die Komponente (ac) liegt vorzugsweise in einer Menge von 15 bis 65 Gew.-% vor.

Wenn (aa') in dem Gemisch enthalten ist, kann es in einem Mengenanteil von 10 bis 90 Gew.-% vorliegen.

Beispiele für bevorzugte Lösemittelgemische (a) sind

1. 1-Ethoxy-2-propanol/Butanon/Methanol
2. 1-Ethoxy-2-propanol/Tetrahydrofuran/Methanol
3. Ethoxypropylacetat/Butanon/Methanol
4. 1-Methoxy-2-propanol/Butanon/Methanol
5. 1-Methoxy-2-propanol/Ethylacetat/Methanol
6. 1-Methoxy-2-propanol/Methanol/Tetrahydrofuran

7. Ethyllactat/Butanon/Methanol

Vorzugsweise werden als Lösemittel b) Propylencarbonat, Dimethylsulfoxid, Diethylenglykolmonomethylether, Diethylenglykoldimethylether, Diethylenglykolmonoethylether, γ-Butyrolacton und N-Methylpyrrolidon oder Mischungen davon eingesetzt.

Durch Zusatz des Lösemittels (b) wird in praktisch allen Fällen eine Steigerung der Lichtempfindlichkeit der damit hergestellten Beschichtungen erreicht. Es wurde gefunden, daß bei Zusätzen von mehr als etwa 5 Gew.-% des Lösemittels (b) die lichtempfindlichkeitssteigernde Wirkung wieder abnimmt. Darüber hinaus verschlechtert sich bei Zusätzen oberhalb 4,5 Gew.-% die Gleichmäßigkeit der Schicht während des Trocknungsvorgangs. Dies ist insbesondere dann der Fall, wenn das höher siedende Lösemittel (b) einen Siedepunkt von mehr als etwa 200 °C aufweist, da dann die Gefahr der Bildung einer wolkigen Schichtstruktur größer ist.

Die mit dem erfindungsgemäßen Lösemittelgemisch hergestellte Beschichtungslösung enthält als weitere Bestandteile eine lichthärtbare Diazoverbindung und ein polymeres Bindemittel. Die Diazoverbindung ist vorzugsweise ein Diazoniumsalz-Polykondensationsprodukt; als Bindemittel wird bevorzugt ein wasserunlösliches, in wäßrig-alkalischen Lösungen lösliches Polymeres, insbesondere ein Polymeres mit seitenständigen Carboxyl- oder Sulfonylurethangruppen, eingesetzt.

Besonders bevorzugte Bindemittel sind Umsetzungsprodukte eines intramolekularen Anhydrids einer organischen Polycarbonsäure mit einem Hydroxylgruppen enthaltenden synthetischen Polymeren, das keine weiteren zur Umsetzung mit Säureanhydriden befähigten funktionellen Gruppen enthält.

Das Säureanhydrid leitet sich bevorzugt von einer Di-oder Tricarbonsäure, insbesondere einer Dicarbonsäure, ab und kann einen, zwei oder mehrere Ringe enthalten.

Bevorzugt werden die Reaktionsprodukte mit Malein-, Phthal-, Bernstein- und 3-Oxa-glutarsäureanhydrid.

Als Hydroxygruppen enthaltende synthetische Polymere kommen insbesondere Polymere mit Vinylalkoholeinheiten, aber auch Epoxidharze und verseifte Epoxidharze, Copolymere von Allylalkohol oder höheren ungesättigten Alkoholen, Polyhydroxyalkylacrylate und -methacrylate und ähnliche Polymerisate in Betracht.

Als Polymere mit Vinylalkoholeinheiten sind teilverseifte Polyvinylester, Polyvinylacetale mit freien Hydroxygruppen sowie entsprechende Umsetzungsprodukte von Copolymeren bzw. Copolymerisaten mit Vinylester- oder Vinylacetal- oder Vinylalkoholeinheiten geeignet.

Das Molekulargewicht der Carboxylgruppen enthaltenden Bindemittel liegt im allgemeinen zwischen 5.000 und etwa 200.000, vorzugsweise zwischen 10.000 und 100.000. Die Säurezahl der Bindemittel kann im allgemeinen zwischen 5 und 80, bevorzugt zwischen 10 und 70 liegen. Diese bevorzugten Bindemittel sind in der EP-A 152 819 näher beschrieben.

Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Diese Kondensationsprodukte sind in der DE-A 20 24 244 beschrieben. Allgemein sind alle Diazoniumsalz-Polykondensationsprodukte geeignet, die in der DE-A 27 39 774 beschrieben sind.

Die Diazoniumsalzeinheiten $A-N_2X$ leiten sich bevorzugt von Verbindungen der Formel $(R^1-R^2-)_pR^3-N_2X$ ab, wobei

$X$       das Anion der Diazoniumverbindung,

$p$       eine ganze Zahl von 1 bis 3,

$R^1$       einen aromatischen Rest mit mindestens einer zur Kondensation mit aktiver Carbonylverbindung befähigten Position,

$R^3$       eine Phenylengruppe,

$R^2$       eine Einfachbindung oder eine der Gruppen:

$$-(CH_2)_q-NR^4-,$$
$$-O-(CH_2)_r-NR^4-,$$
$$-S-(CH_2)_r-NR^4-,$$
$$-S-CH_2CO-NR^4-,$$
$$-O-R^5-O-,$$
$$-O-$$
$$-S-$$

oder

$$-CO-NR^4-$$

bedeuten, worin

$q$       eine Zahl von 0 bis 5,

EP 0 410 277 B1

r     eine Zahl von 2 bis 5,

$R^4$     Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und

$R^5$     eine Arylengruppe mit 6 bis 12 C-Atomen ist.

Die erfindungsgemäßen Lösungen enthalten im allgemeinen 5 bis 90, bevorzugt 10 bis 70 Gew.-% Diazoniumverbindung und 95 bis 10, bevorzugt 90 bis 30 Gew.-% polymeres Bindemittel, bezogen auf die Summe der nichtflüchtigen Bestandteile.

Zur Stabilisierung der Lösung bzw. der damit erhaltenen Schicht ist es vorteilhaft, dieser eine Verbindung mit Säurecharakter zuzusetzen. In Betracht kommen Mineralsäuren und starke organische Säuren, von denen Phosphorsäure, Schwefelsäure, Perchlorsäure, Borsäure oder p-Toluolsulfonsäure bevorzugt werden. Eine besonders gut geeignete Säure ist die Phosphorsäure.

Den Lösungen können ferner Weichmacher, Haftvermittler, Farbstoffe, Pigmente und Farbbildner zugesetzt werden.

Als mit der erfindungsgemäßen Lösung zu beschichtende Schichtträger eignen sich z. B. Magnesium, Zink, Kupfer, mechanisch, chemisch und elektrochemisch aufgerauhtes Aluminium, anodisiertes Aluminium, Stahl, aber auch Polyester- oder Celluloseacetatfolie, Perlongaze etc., deren Oberfläche bei Bedarf einer Vorbehandlung unterworfen sein kann. Das Trägermaterial kann dabei als endgültiger Schichtträger fungieren oder als temporäres Trägermaterial, von dem die lichtempfindliche Schicht auf das zu bearbeitende Werkstück mittels Laminieren übertragen wird.

Das mit den lichtempfindlichen Lösungen hergestellte Aufzeichnungsmaterial dient einerseits zur Herstellung von Bildern auf geeigneten Trägern bzw. Empfangsblättern, andererseits zur Herstellung von Reliefs, die als Druckformen, Siebe, Reservagen und dgl. Anwendung finden.

Darüber hinaus ist es aber auch möglich, die Lösungen zur Herstellung von durch UV-Strahlung härtbaren Lacken zu verwenden, die als Oberflächenschutz eingesetzt werden können, oder zur Formulierung von UV-härtbaren Druckfarben.

Besonders bevorzugt wird die Lösung zur Herstellung von Flachdruckformen verwendet, wobei als Trägermaterial Aluminium bevorzugt wird.

Besonders bevorzugt wird Aluminium, das für diesen Zweck in üblicher Weise vorbehandelt wird, z. B. durch mechanisches, chemisches oder elektrochemisches Aufrauhen und ggf. anschließende anodische Oxidation. Eine weitere Behandlung dieses Trägermaterials, z. B. mit Polyvinylphosphonsäure, Alkalisilikat, Phosphat, Hexafluorozirkonat, Chromat, Borat, Polyacrylamid und Cellulosederivaten, ist vorteilhaft.

Die Verarbeitung der aus den Beschichtungslösungen erhaltenenen Aufzeichnungsmaterialien erfolgt in bekannter Weise durch bildmäßiges Belichten und Auswaschen der unbelichteten Schichtbereiche mit einem geeigneten Entwickler.

Die Belichtung des Aufzeichnungsmaterials erfolgt in bekannter Weise unter einer Vorlage mit Kopierlichtquellen, die einen möglichst hohen Spektralanteil im nahen Ultraviolettbereich emittieren. Sie kann auch durch Laserbestrahlung erfolgen. Geeignet für die Bestrahlung sind leistungsgerechte kürzerwellige Laser, beispielsweise Ar-Laser, Krypton-Ionen-Laser, Helium/Cadmium-Laser, die etwa zwischen 300 und 600 nm emittieren, aber für einige Schichten auch $CO_2$-Laser, welche bei 10,6 µm emittieren, oder YAG-Laser, die bei 1,06 µm emittieren.

Als Entwicklerlösungen werden neutrale oder alkalische wäßrige Lösungen mit einem pH-Wert im Bereich von 6 bis 14, vorzugsweise 7,5 bis 12, verwendet, die Puffersalze, z. B. wasserlösliche Alkaliphosphate, -silikate, -borate, -carbonate, -acetate oder -benzoate, enthalten. Als weitere Bestandteile werden Netzmittel, vorzugsweise anionische Netzmittel, und ggf. wasserlösliche Polymere verwendet. Die Lösung kann auch geringe Mengen, z. B. bis zu 5, bevorzugt nicht mehr als 2 Gew.-% an mit Wasser mischbaren organischen Lösungsmitteln enthalten. Bevorzugt werden schwerflüchtige Lösungsmittel, z.B. araliphatische Alkohole, deren Dampfdruck bei der Handhabung des Entwicklers nicht ins Gewicht fällt.

Die Entwicklung kann in bekannter Weise durch Tauchen, Besprühen, Bürsten oder Tamponieren erfolgen.

Die Erfindung wird anhand der folgenden Beispiele näher erläutert. Im folgenden sollen unter den Prozentangaben stets Gewichtsprozente verstanden werden; Mengenverhältnisse sind, wenn nichts anderes angegeben ist, Gewichtsverhältnisse.

Vergleichsbeispiel V1

Eine Beschichtungslösung aus

4,17 g     des Umsetzungsprodukts aus einem Polyvinylbutyral mit einem Molekulargewicht von etwa 70.000 bis 80.000, das 71 % Vinylbutyral-, 2 % Vinylacetat- und 27 % Vinylalkoholeinheiten enthält, und Maleinsäureanhydrid mit der Säurezahl 30,

5

| 1,41 g | eines Diazoniumsalz-Polykondensationsprodukts, hergestellt aus 1 mol 3-Methoxy-diphenylamin-4-diazoniumsulfat und 1 mol 4,4'-Bis-methoxymethyl-diphenylether in 85%iger Phosphorsäure und isoliert als Mesitylensulfonat, |
|---|---|
| 0,17 g | Phosphorsäure (85%ig), |
| 0,20 g | Renolblau B2G-HW (C.I. 74 160), |
| 0,047 g | Phenylazodiphenylamin in |
| 174 g | Ethylenglykolmonomethylether und |
| 20 g | Butanon |

wird im Kisscoat-Verfahren auf eine in Salpetersäure elektrochemisch aufgerauhte und anschließend in Schwefelsäure anodisierte Aluminiumfolie, die mit Polyvinylphosphonsäure nachbehandelt worden ist, aufgebracht. Das Trockenschichtgewicht beträgt 1,07 g/m².

Die so erhaltene Druckplattenprobe wird unter einer Negativvorlage 20 s lang mit einer 5-kW-Metallhalogenidlampe in ca. 110 cm Abstand belichtet. Anschließend wird mit einem Entwickler folgender Zusammensetzung entwickelt:

| 1,3 g | Dodecylbenzolsulfonsäure/Na-Salz, |
|---|---|
| 4 g | Ethylenglykolmonophenylether, |
| 2 g | Grahamsalz, |
| 0,5 g | Poly-N-vinyl-N-methylacetamid, |
| 4 g | Pelargonsäure, |
| 1,4 g | KOH fest und |
| 1 g | $K_2B_4O_7 \cdot 4H_2O$ in |
| 85,8 g | entionisiertem Wasser |

Die Entwicklung erfolgt 45 s lang mit einem Plüschtampon.

Die nichtbelichteten Schichtbereiche werden dabei sauber entfernt. Anschließend wird mit Wasser nachgespült. In der entwickelten Kopie ist die Stufe 5 eines Silberfilm-Halbtonstufenkeils mit 13 Stufen und Dichteinkrementen von 0,15 noch voll gedeckt wiedergegeben.

## Vergleichsbeispiel V2

Das Lösemittelgemisch Ethylenglykolmonomethylether (Methylglykol) und Butanon von V1 wird jetzt durch ein Lösemittelgemisch mit höherem MAK-Wert, nämlich durch 1-Ethoxy-2-propanol (Sp 134 °C, MAK 100 ppm), Butanon (Sp 79,6 °C, MAK 200 ppm) und Methanol (Sp 65 °C, MAK 200 ppm) ersetzt, d.h. es wird kein 2-Methoxy-ethanol verwendet.

Eine Beschichtungslösung aus

| 4,17 g | des in V1 beschriebenen Polymeren, |
|---|---|
| 1,41 g | des in V1 beschriebenen Diazoniumsalz-Polykondensates, |
| 0,17 g | Phosphorsäure (85%ig), |
| 0,20 g | Renolblau B2G-HW (C.I. 74 160), |
| 0,047 g | Phenylazodiphenylamin in |
| 77,6 g | 1-Ethoxy-2-propanol, |
| 58,2 g | Methylethylketon und |
| 58,2 g | Methanol |

wird auf den gleichen Al-Träger wie in V1 beschichtet, wobei ein Schichtgewicht von 1,05 g/m² erzielt wird. Belichtung und Entwicklung der lichtempfindlichen Schicht erfolgen ebenfalls wie in V1. In der Kopie ist jedoch jetzt - im Gegensatz zu V1 - nur noch die Stufe 3 voll gedeckt, d.h. die Schicht weist nach der Eliminierung des 2-Methoxy-ethanols eine um zwei Keilstufen geringere Lichtempfindlichkeit auf.

## Beispiel 1

Der nachfolgenden Beschichtungslösung wird 1 Gew.-% (= 1,94 g) Propylencarbonat (Sp 241 °C), bezogen auf die Gesamtlösemittelmenge, auf Kosten der Methanolmenge gemäß V2 zugesetzt.

Eine Beschichtungslösung aus

| 4,17 g | des in V1 beschriebenen Polymeren, |
|---|---|
| 1,41 g | des in V1 beschriebenen Diazoniumsalz-Polykondensates, |
| 0,17 g | Phosphorsäure (85%ig), |
| 0,20 g | Renolblau B2G-HW (C.I. 74 160), |
| 0,047 g | Phenylazodiphenylamin in |
| 77,6 g | 1-Ethoxy-2-propanol, |

58,2 g      Methylethylketon,
56,26 g     Methanol,
1,94 g      Propylencarbonat

wird auf den gleichen Al-Träger wie in V1 mit einem Schichtgewicht von 1,14 g/m$^2$ beschichtet, wie in V1 belichtet und entwickelt. In der Kopie ist jetzt wieder die Stufe 5 voll gedeckt.

Beispiel 2

Die 1,94 g Propylencarbonat im Beispiel 1 werden durch 1,94 g Dimethylsulfoxid (Sp 189 °C) ersetzt. Nach gleicher Verarbeitung der Beschichtungslösung wie in V1 ergibt sich ein Schichtgewicht von 1,03 g/m$^2$. Wie in V1 ist in der Kopie die Stufe 5 voll gedeckt.

Beispiel 3

Das Propylencarbonat des Beispiels 1 wird durch 1,94 g Diethylenglykolmonomethylether (Sp 193 °C) ersetzt. Nach gleicher Verarbeitung der Beschichtungslösung wie in V1 wird ein Schichtgewicht von 1,07 g/m$^2$ erhalten. Wie in den Beispielen V1, 1 und 2 ist in der Kopie die Stufe 5 voll gedeckt.

Beispiel 4

Anstelle des Propylencarbonats in Beispiel 1 werden 1,94 g $\gamma$-Butyrolacton (Sp 204 °C) zugesetzt. Nach gleicher Verarbeitung wie in V1 ergibt sich ein Schichtgewicht von 1,0 g/m$^2$, in der Kopie ist wie in den Beispielen V1 und 1 bis 3 die Stufe 5 voll gedeckt.

Vergleichsbeispiel V3 und Beispiele 5 bis 7

In den folgenden Beispielen wird das Lösemittelsystem 1-Ethoxy-2-propanol/Methanol/Tetrahydrofuran eingesetzt.

4,17 g      des in V1 beschriebenen Polymeren,
1,41 g      des in V1 beschriebenen Diazoniumsalz-Polykondensates,
0,168 g     Phosphorsäure (85%ig),
0,20 g      Renolblau B2G-HW (C.I. 74 160),
0,047 g     Phenylazodiphenylamin werden in
194 g       des in Tabelle 1 aufgeführten Lösemittelsystems

gelöst und wie in V1 weiterverarbeitet. Es ergeben sich folgende Resultate:

7

Tabelle 1

| Lösemittel | Siede-punkt | Vergleichs-beispiel | Beispiele | | |
|---|---|---|---|---|---|
| | °C | V3 | 5 | 6 | 7 |
| 1-Ethoxy-2-propanol | 134 | 30 % | 30 % | 30 % | 30 % |
| Methanol | 65 | 30 % | 29 % | 28 % | 26 % |
| Tetrahydrofuran | 66 | 40 % | 40 % | 40 % | 40 % |
| Propylencarbonat | | – | 1 % | 2 % | 4 % |
| Schichtgewicht g/m² | | 0,96 | 1,09 | 1,05 | 0,97 |
| gedeckte Stufe | | 3 | 5 | 5-6 | 5-6 |

Vergleichsbeispiel V4

In dem folgenden Beispiel wird das Lösemittelsystem 1-Ethoxy-2-propanol/Methylethylketon/Wasser verwendet.

| | |
|---|---|
| 4,17 g | des in V1 beschriebenen Polymeren, |
| 1,41 g | des in V1 beschriebenen Diazoniumsalz-Polykondensates, |
| 0,168 g | Phosphorsäure (85%ig), |
| 0,20 g | Renolblau B2G-HW (C.I. 74 160), |
| 0,047 g | Phenylazodiphenylamin, |
| 0,030 g | eines modifizierten Siloxanglykolcopolymeren (Additiv) |
| | werden in |
| 194 g | des in Tabelle 2 angegebenen Lösemittelgemisches |

gelöst, nach der Beschichtung 30 s lang belichtet und wie in V1 weiterverarbeitet. Es wird folgendes Resultat erzielt:

## Tabelle 2

| Lösemittel | Siede-punkt | Menge |
|---|---|---|
| | °C | |
| 1-Ethoxy-2-propanol | 134 | 40 % |
| Wasser, vollentsalzt | 100 | 20 % |
| Methylethylketon | 79,6 | 40 % |
| Propylencarbonat | 241 | − |
| Schichtgewicht g/m$^2$ | | 0,96 |
| gedeckte Stufe | | 4 |

### Vergleichsbeispiel V5

In dem folgenden Beispiel wird das Lösemittelsystem 1-Ethoxy-2-propanol/Ethyllactat/Wasser benutzt.

| | |
|---|---|
| 4,17 g | des in V1 beschriebenen Polymeren, |
| 1,41 g | des in V1 beschriebenen Diazoniumsalz-Polykondensates, |
| 0,168 g | Phosphorsäure (85%ig), |
| 0,20 g | Viktoriareinblau FGA (C.I. Basic Blue 81), |
| 0,047 g | Phenylazodiphenylamin, |
| 0,020 g | eines modifizierten Siloxanglykolcopolymeren werden in |
| 194 g | des in Tabelle 3 angegebenen Lösemittelgemisches |

gelöst, nach der Beschichtung 35 s lang belichtet und wie in V1 weiterverarbeitet. Es wird folgendes Ergebnisse erzielt:

Tabelle 3

| Lösemittel | Siede-punkt °C | Menge |
|---|---|---|
| 1-Ethoxy-2-propanol | 134 | 50 % |
| Ethyllactat | 154 | 40 % |
| Wasser, vollentsalzt | 100 | 10 % |
| Propylencarbonat | 241 | - |
| Schichtgewicht g/m$^2$ | | 2,02 |
| gedeckte Stufe | | 4 |

Vergleichsbeispiel V6 und Beispiele 8 bis 11

In den folgenden Beispielen wird das Lösemittelsystem Ethoxypropylacetat/Methylethylketon/Methanol angewendet, das bei Zusatz geringer Mengen eines höher siedenden Lösemittels gleichfalls eine Lichtempfindlichkeitssteigerung zeigt.

| | |
|---|---|
| 4,17 g | des in V1 beschriebenen Polymeren, |
| 1,41 g | des in V1 beschriebenen Diazoniumsalz-Polykondensates, |
| 0,17 g | Phosphorsäure (85%ig), |
| 0,20 g | Renolblau B2G-HW (C.I. 74 160), |
| 0,047 g | Phenylazodiphenylamin werden in |
| 194 g | des in Tabelle 4 angegebenen Lösemittelgemisches |

gelöst, auf einen Al-Träger gemäß V1 beschichtet, wie in V1 belichtet und entwickelt. Danach erhält man die folgenden Ergebnisse:

## Tabelle 4

| Lösemittel | Siede-punkt | Vergleichs-beispiel | Beispiele | | | |
|---|---|---|---|---|---|---|
| | °C | V6 | 8 | 9 | 10 | 11 |
| Ethoxypropylacetat | 174,5 | 40 % | 40 % | 40 % | 40 % | 40 % |
| Methylethylketon | 79,6 | 30 % | 30 % | 30 % | 30 % | 30 % |
| Methanol | 65 | 30 % | 29 % | 29 % | 29 % | 29 % |
| Propylencarbonat | 241 | – | 1 % | – | – | – |
| Dimethylsulfoxid | 189 | – | – | 1 % | – | – |
| Diglykolmonomethyl-ether | 193 | – | – | – | 1 % | – |
| $\gamma$-Butyrolacton | 204 | – | – | – | – | 1 % |
| Schichtgewicht g/m$^2$ | | 1,06 | 1,08 | 1,02 | 1,01 | 1,01 |
| gedeckte Stufe | | 3 | 5 | 4 | 4 | 4 |

### Vergleichsbeispiel V7

Das Lösemittelgemisch Ethylenglykolmonomethylether und Methylethylketon aus V1 wird hier durch 1-Methoxy-2-propanol (Sp 122 °C, MAK 100 ppm), Methylethylketon und Methanol ersetzt.

Eine Beschichtungslösung aus

| | |
|---|---|
| 4,17 g | des in V1 beschriebenen Polymeren, |
| 1,41 g | des in V1 beschriebenen Diazoniumsalz-Polykondensates, |
| 0,17 g | Phosphorsäure (85%ig), |
| 0,20 g | Renolblau B2G-HW (C.I. 74 160), |
| 0,047 g | Phenylazodiphenylamin, |
| 64,2 g | 1-Methoxy-2-propanol |
| 48,2 g | Methylethylketon und |
| 48,2 g | Methanol |

wird auf den gleichen Al-Träger wie in V1 aufgebracht, wobei ein Schichtgewicht von 1,05 g/m$^2$ erzielt wird. Belichtung und Entwicklung der lichtempfindlichen Schicht erfolgen gemäß V1. In der Kopie ist jedoch jetzt - im Gegensatz zu V1 - nur noch die Stufe 4 voll gedeckt, d.h. die Schicht weist nach der Eliminierung des Methylglykols eine um eine Keilstufe geringere Lichtempfindlichkeit auf. Auch die Gradation ist flacher.

### Beispiel 12

In der folgenden Beschichtungslösung wird 1 Gew.-% (= 1,606 g) Propylencarbonat (Sp 241 °C), bezogen auf die Gesamtlösemittelmenge (= 160,6 g) auf Kosten der in V7 verwendeten Methanolmenge zugesetzt.

Eine Beschichtungslösung aus

| | |
|---|---|
| 4,17 g | des in V1 beschriebenen Polymeren, |
| 1,41 g | des in V1 beschriebenen Diazoniumsalz-Polykondensates, |
| 0,17 g | Phosphorsäure (85%ig), |

| 0,20 g | Renolblau B2G-HW (C.I. 74 160), |
| 0,047 g | Phenylazodiphenylamin in |
| 64,2 g | 1-methoxy-2-propanol, |
| 48,2 g | Methylethylketon, |
| 46,594 g | Methanol und |
| 1,606 g | Propylencarbonat |

wird auf einen Al-Träger gemäß V1 mit einem Schichtgewicht von 1,04 g/m$^2$ aufgebracht. Nach der Belichtung und Entwicklung wie in V1 ist die Stufe 5 in der Kopie jetzt wieder voll gedeckt, und es liegt auch wieder die steilere Gradation von V1 vor.

### Beispiel 13

In der folgenden Beschichtungslösung wird das Propylencarbonat gemäß Beispiel 12 durch 1,606 g Dimethylsulfoxid (Sp 189 °C) ersetzt und wie in V1 verarbeitet. Es ergibt sich ein Schichtgewicht von 1,04 g/m$^2$. Wie in V1 und Beispiel 12 ist in der Kopie die Stufe 5 voll gedeckt und die steile Gradation von V1 erreicht.

### Beispiel 14

Das Propylencarbonat des Beispiels 12 wird durch 1,606 g Diglykolmonomethylether (Sp 193 °C) ersetzt. Nach Verarbeitung der Beschichtungslösung gemäß V1 wird ein Schichtgewicht von 1,01 g/m$^2$ erhalten. In der Kopie ist - wie in den Beispielen V1, 12 und 13 - die Stufe 5 voll gedeckt.

### Beispiel 15

Anstelle des Propylencarbonats in Beispiel 12 werden 1,606 g γ-Butyrolacton (Sp 204 °C) zugesetzt. Nach gleicher Verarbeitung der Beschichtungslösung wie in V1 ergibt sich ein Schichtgewicht von 1,05 g/m$^2$. In der Kopie ist - wie in den Beispielen V1 und 12 bis 14 - die Stufe 5 voll gedeckt und die steile Gradation gemäß V1 wiederhergestellt.

### Vergleichsbeispiel V8 und Beispiele 16 bis 23

In dieser Versuchsreihe wird die Abhängigkeit der Lichtempfindlichkeit von der Konzentration des höher siedenden Lösemittels (Propylencarbonat) im Konzentrationsbereich von 0,1 bis 7 % veranschaulicht.

| 4,17 g | des in V1 beschriebenen Polymeren, |
| 1,41 g | des in V1 beschriebenen Diazoniumsalz-Polykondensates, |
| 0,17 g | Phosphorsäure (85%ig), |
| 0,20 g | Renolblau B2G-HW (C.I. 74 160), |
| 0,047 g | Phenylazodiphenylamin werden in |
| 194 g | des in Tabelle 5 angegebenen Lösemittelgemisches |

gelöst und wie in V1 weiterverarbeitet. Dabei werden die in Tabelle 5 aufgeführten Resultate erzielt.

Tabelle 5

| Lösemittel | Siedepunkt °C | Vergleichsbeispiel V8 | Beispiele 16 | 17 | 18 | 19 | 20 | 21 | 22 | 23 |
|---|---|---|---|---|---|---|---|---|---|---|
| Methoxypropanol | 122 | 40 % | 40 % | 40 % | 40 % | 40 % | 40 % | 40 % | 40 % | 40 % |
| Methylethylketon | 79,6 | 30 % | 30 % | 30 % | 30 % | 30 % | 30 % | 30 % | 30 % | 30 % |
| Methanol | 65 | 30 % | 29,9% | 29,75% | 29,5% | 29 % | 28 % | 27 % | 25 % | 23 % |
| Propylencarbonat | 241 | - | 0,1% | 0,25% | 0,5% | 1 % | 2 % | 3 % | 5 % | 7 % |
| Schichtgewicht g/m² | | 1,05 | 1,04 | 1,04 | 1,04 | 1,04 | 1,02 | 1,0 | 1,01 | 1,02 |
| gedeckte Stufe | | 4 | 4-5 | 5 | 5 | 5 | 6 | 6 | 6 | 5-6 |

Vergleichsbeispiel V9 und Beispiele 24 bis 26

In den folgenden Beispielen kommen ein kleineres Bindemittel/Diazoniumsalz-Verhältnis von 2:1 und ein anderer Farbstoff zur Anwendung. Beschichtung, Belichtung und Entwicklung erfolgen gemäß V1.
54,48 g einer 7,8%igen Lösung des in V1 beschriebenen Polymeren in Methylethylketon,

2,12 g    des in V1 beschriebenen Diazoniumsalz-Polykondensates,
0,25 g    Phosphorsäure (85%ig),
0,30 g    Viktoriareinblau FGA (C.I. Basic Blue 81),
0,07 g    Phenylazodiphenylamin,
142,77 g  Lösemittelgemisch lt. Tabelle 6, so daß die Gesamtlösemittelmenge einschließlich der 50,23 g Methylethylketon aus der 7,8%igen Polymerlösung 193 g beträgt.

## Tabelle 6

| Lösemittel | Siede-punkt | Vergleichs-beispiel | Beispiele | | |
|---|---|---|---|---|---|
| | °C | V9 | 24 | 25 | 26 |
| 1-Methoxy-2-propanol | 122 | 54 % | 53,5% | 51,5% | 49 % |
| Methylethylketon | 79,6 | 26 % | 26 % | 26 % | 26 % |
| Methanol | 65 | 20 % | 20 % | 20 % | 20 % |
| Propylencarbonat | 241 | – | 0,5% | 2,5% | 5 % |
| Schichtgewicht g/m$^2$ | | 1,0 | 1,0 | 1,06 | 1,07 |
| gedeckte Stufe | | 3 | 3-4 | 4 | 4 |

In den folgenden Beispielen wird ein Bindemittel/Diazoniumsalz-Verhältnis von 1:1 angewandt.

### Vergleichsbeispiel V10

Eine Beschichtungslösung aus
36,78 g    einer 8,1%igen Lösung des in V1 beschriebenen Polymeren in Methylethylketon,
2,98 g     des in V1 beschriebenen Diazoniumsalz-Polykondensates,
0,136 g    Phosphorsäure (85%ig),
0,78 g     Renolblau B2G-HW (C.I. 74 160),
0,05 g     Phenylazodiphenylamin,
77,22 g    1-Methoxy-2-propanol,
57,91 g    Methanol,
24,11 g    Methylethylketon (Gesamtmenge 57,91 g)
wird gemäß V1 auf den dort beschriebenen Al-Träger mit einem Trockenschichtgewicht von 1,05 g/m$^2$ aufgebracht, wie in V1 belichtet und entwickelt. Die Keilstufe 4 ist voll gedeckt.

### Beispiel 27

Es wird eine Beschichtungslösung gemäß V10 hergestellt, jedoch mit
55,98 g    Methanol (statt 57,91 g) und zusätzlich
1,93 g     Propylencarbonat (= 1 Gew.-% der Gesamtlösemittelmenge)
Die Lösung wird gemäß V1 verarbeitet. Das Trockenschichtgewicht beträgt wiederum 1,05 g/m$^2$. Die Stufe 5 ist voll gedeckt.

### Beispiel 28

Es wird eine Beschichtungslösung gemäß Beispiel 27 hergestellt, jedoch werden anstelle von 1,93 g Propylencarbonat 1,93 g Methylpyrrolidon eingesetzt. Es ergibt sich ein Schichtgewicht von 1,0 g/m². In der Kopie ist die Stufe 5 gedeckt.

Vergleichsbeispiel V11 und Beispiele 29 bis 31

In den folgenden Beispielen kommt das Lösemittelsystem 1-Methoxy-2-propanol/Methanol/Ethylacetat zur Anwendung.

| | |
|---|---|
| 4,17 g | des in V1 beschriebenen Polymeren, |
| 1,41 g | des in V1 beschriebenen Diazoniumsalz-Polykondensates, |
| 0,168 g | Phosphorsäure (85%ig), |
| 0,20 g | Renolblau B2G-HW (C.I. 74 160), |
| 0,047 g | Phenylazodiphenylamin werden in |
| 194 g | des in Tabelle 7 aufgeführten Lösemittelgemisches |

gelöst und gemäß V1 weiterverarbeitet.

## Tabelle 7

| Lösemittel | Siede-punkt | Vergleichs-beispiel | Beispiele | | |
|---|---|---|---|---|---|
| | °C | V11 | 29 | 30 | 31 |
| 1-Methoxy-2-propanol | 122 | 40 % | 40 % | 40 % | 40 % |
| Methanol | 65 | 40 % | 39 % | 38 % | 36 % |
| Ethylacetat | 72,2 | 20 % | 20 % | 20 % | 20 % |
| Propylencarbonat | 241 | – | 1 % | 2 % | 4 % |
| Schichtgewicht g/m² | | 1,0 | 1,06 | 0,95 | 0,95 |
| gedeckte Stufe | | 4 | 5 | 6 | 6 |

Vergleichsbeispiel V12

Das folgende Beispiel wird mit dem Lösemittelsystem 1-Methoxy-2-propanol/Methylethylketon/Wasser und einer stärker wasserlöslichen Diazoverbindung durchgeführt.

Es wird eine Beschichtungslösung hergestellt aus

| | |
|---|---|
| 2,56 g | des in V1 beschriebenen Polymeren, |
| 2,56 g | eines Diazoniumsalz-Polykondensationsprodukts, hergestellt aus mol 3-Methoxy-diphenylamin-4-diazoniumsulfat und 1 mol 4,4'-Bis-methoxymethyl-diphenylether in 85%iger Phosphorsäure und isoliert als Methansulfonat, |
| 0,118 g | Phosphorsäure (85%ig), |
| 0,5 g | Renolblau B2G-HW (C.I. 74 160), |
| 0,046 g | Phenylazodiphenylamin, |
| 0,02 g | eines modifizierten Siloxanglykolcopolymeren (Additiv), |
| | gelöst in |
| 194 g | des in Tabelle 8 angegebenen Lösemittelgemisches. |

Die Weiterverarbeitung erfolgt gemäß V1. Folgendes Resultat wird erzielt:

## Tabelle 8

| Lösemittel | Siede-punkt | Menge |
|---|---|---|
| | °C | . |
| 1-Methoxy-2-propanol | 122 | 50 % |
| Methylethylketon | 79,6 | 30 % |
| Wasser, vollentsalzt | 100 | 20 % |
| Propylencarbonat | 241 | – |
| Schichtgewicht g/m$^2$ | | 1,07 |
| gedeckte Stufe | | 3 |

Vergleichsbeispiel V13

Eine Beschichtungslösung aus

| | |
|---|---|
| 30,16 g | einer 12%igen Lösung des Umsetzungsprodukts des in V1 angegebenen Polyvinylbutyrals mit Propenylsulfonylisocyanat mit der Säurezahl 144 in Tetrahydrofuran, |
| 1,81 g | des in V1 beschriebenen Diazoniumsalz-Polykondensates, |
| 0,21 g | Phosphorsäure (85%ig), |
| 0,25 g | Viktoriareinblau FGA (C.I. Basic Blue 81), |
| 0,06 g | Phenylazodiphenylamin, |
| 128,66 g | 1-Methoxy-2-propanol, |
| 38,8 g | Methanol |

wird gemäß V1 auf den dort genannten Al-Träger aufgebracht, wobei ein Schichtgewicht von 1,02 g/m$^2$ erhalten wird. Nach Belichtung und Entwicklung gemäß V1 ist die Keilstufe 3 voll gedeckt.

Vergleichsbeispiel V14 und Beispiele 32 bis 34

Auch das Lösemittelsystem Ethyllactat/Methanol/Methylethylketon zeigt bei Zugabe geringer Mengen eines höher siedenden Lösemittels eine lichtempfindlichkeitssteigernde Wirkung.

Es wird eine Beschichtungslösung aus

| | |
|---|---|
| 3,0 g | des in V1 beschriebenen Polymeren, |
| 3,0 g | des in V1 beschriebenen Diazoniumsalz-Polykondensates, |
| 0,138 g | Phosphorsäure (85%ig), |
| 0,79 g | Renolblau B2G-HW (C.I. 74 160), |
| 0,054 g | Phenylazodiphenylamin, gelöst in |
| 193 g | des in Tabelle 9 aufgeführten Lösemittelgemisches |

hergestellt und gemäß V1 weiterverarbeitet. Dabei werden folgende Ergebnisse erzielt:

## Tabelle 9

| Lösemittel | Siede-punkt | Vergleichs-beispiel | Beispiele | | |
|---|---|---|---|---|---|
| | °C | V14 | 32 | 33 | 34 |
| Ethyllactat | 154 | 20 % | 20 % | 20 % | 20 % |
| Methanol | 65 | 20 % | 19 % | 18 % | 16 % |
| Methylethylketon | 79,6 | 60 % | 60 % | 60 % | 60 % |
| Propylencarbonat | 241 | – | 1 % | 2 % | 4 % |
| Schichtgewicht g/m² | | 0,98 | 1,0 | 1,01 | 1,0 |
| gedeckte Stufe | | 4 | 5 | 5 | 5 |

Die lichtempfindlichen Gemische können auch kleine Partikel mit einem mittleren Durchmesser zwischen 1 und 10 μm, mindestens jedoch so groß wie die Dicke der lichtempfindlichen Schicht, enthalten, die eine rauhe Oberfläche der Negativdruckplatten bewirken, um dadurch die Evakuierzeit im Belichtungsrahmen zu reduzieren.

In Frage kommen anorganische Pigmente wie Siliziumoxid, Aluminiumoxid, Aluminiumsilikat, Zinkoxid, Titandioxid u. a. oder organische Polymerteilchen.

Weiterhin können den lichtempfindlichen Zusammensetzungen oberflächenaktive Substanzen wie z. B. Methylpolysiloxane oder Fluortenside zugesetzt werden, um die Verlaufseigenschaften zu verbessern.

**Patentansprüche**

1. Beschichtungslösung zur Herstellung eines lichtempfindlichen Aufzeichnungsmaterials, die als wesentliche Bestandteile eine lichthärtbare Verbindung, ein polymeres Bindemittel und ein Lösemittelgemisch enthält, dadurch gekennzeichnet, daß das Lösemittelgemisch ein Gemisch aus

    a) einem Gemisch aus

        aa) einem polaren Lösemittel der Formel

        R-OH,

    worin R eine Alkylgruppe mit 1 - 3 Kohlenstoffatomen ist, oder

    aa') einem Monoalkylether oder einem Alkyletherester des Propylenglykols,

    ab) einem organischen Lösemittel mit einem Siedepunkt im Bereich von 60 bis 160 °C, das ein aliphatisches Keton, ein Alkansäure- oder Hydroxyalkansäurealkylester oder ein cyclischer Ether ist, und

    ac) einem organischen Lösemittel mit einem Siedepunkt im Bereich von 120 bis 180 °C, das ein Monoalkylether oder ein Alkyletherester des Propylenglykols oder ein Alkylester einer Hydroxyalkansäure ist mit der Maßgabe, daß (ac) kein Ether oder Etherester des Propylenglykols ist, wenn (aa') vorhanden ist, und daß (ac) kein Alkylester einer Hydroxyalkansäure ist, wenn (ab) diese Bedeutung hat,

    in solchem Mengenverhältnis, daß ein homogenes Gemisch gebildet wird, und

    b) 0,1 bis 8 Gew.-%, bezogen auf das gesamte Lösemittelgemisch, eines Lösemittels ist, dessen Siedepunkt höher liegt als jeder einzelne Siedepunkt der unter (a) genannten Lösemittel und das ein Lacton, ein cyclischer Ester, der kein Lacton ist, ein Sulfoxid, ein Diglykolether oder ein Lactam ist.

2. Beschichtungslösung nach Anspruch 1, dadurch gekennzeichnet, daß der Siedepunkt des Lösemittels (b) im Bereich von 160 bis 250 °C liegt.

3. Beschichtungslösung nach Anspruch 1, dadurch gekennzeichnet, daß das polare Lösemittel (aa) Methanol ist.

4. Beschichtungslösung nach Anspruch 1, dadurch gekennzeichnet, daß das aliphatische Keton (ab) 3 bis 6 Kohlenstoffatome hat.

5. Beschichtungslösung nach Anspruch 1, dadurch gekennzeichnet, daß der cyclische Ether (ab) Tetrahydrofuran oder Dioxan ist.

6. Beschichtungslösung nach Anspruch 1, dadurch gekennzeichnet, daß der Hydroxyalkansäurealkylester ein Methyl- oder Ethylester der Milch- oder Glykolsäure ist.

7. Beschichtungslösung nach Anspruch 1, dadurch gekennzeichnet, daß das organische Lösemittel (ac) ein Alkylester oder Alkylether mit 1 bis 2 Kohlenstoffatomen in der Alkylgruppe ist.

8. Beschichtungslösung nach Anspruch 1, dadurch gekennzeichnet, daß das Bindemittel wasserunlöslich und in wäßrig-alkalischen Lösungen löslich ist.

9. Beschichtungslösung nach Anspruch 1, dadurch gekennzeichnet, daß die lichthärtbare Verbindung ein Diazoniumsalz-Polykondensationsprodukt ist.

10. Beschichtungslösung nach Anspruch 8, dadurch gekennzeichnet, daß das Bindemittel ein Umsetzungsprodukt eines intramolekularen Anhydrids einer organischen Polycarbonsäure mit einem Hydroxylgruppen enthaltenden Polymeren ist, das keine weiteren zur Umsetzung mit Säureanhydriden befähigten funktionellen Gruppen enthält.

11. Beschichtungslösung nach Anspruch 9, dadurch gekennzeichnet, daß das Diazoniumsalz-Polykondensationsprodukt aus wiederkehrenden Einheiten $A-N_2X$ und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

12. Beschichtungslösung nach Anspruch 11, dadurch gekennzeichnet, daß die Einheiten $A-N_2X$ sich aus Verbindungen der allgemeinen Formel

$$(R^1-R^2-)_pR^3-N_2X$$

ableiten und wobei

X    das Anion der Diazoniumverbindung,
p    eine ganze Zahl von 1 bis 3,
$R^1$    einen aromatischen Rest mit mindestens einer zur Kondensation mit aktiver Carbonylverbindung befähigten Position,
$R^3$    eine Phenylengruppe,
$R^2$    eine Einfachbindung oder eine der Gruppen:

$$-(CH_2)_q-NR^4-,$$
$$-O-(CH_2)_r-NR^4-,$$
$$-S-(CH_2)_r-NR^4-,$$
$$-S-CH_2CO-NR^4-,$$
$$-O-R^5-O-,$$
$$-O-,$$
$$-S-$$

oder

$$-CO-NR^4-$$

bedeuten, worin

q      eine Zahl von 0 bis 5,

r      eine Zahl von 2 bis 5,

$R^4$      Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und

$R^5$      eine Arylengruppe mit 6 bis 12 C-Atomen ist.

## Claims

1. Coating solution for the production of a photosensitive recording material, which contains, as the essential constituents, a photohardenable compound, a polymeric binder, and a solvent mixture, wherein the solvent mixture comprises a mixture comprised of

    a) a mixture comprising

        aa) a polar solvent of the formula R-OH, in which R is an alkyl group having from 1 to 3 carbon atoms, or

        aa′) a monoalkylether or an alkylether ester of propylene glycol,

        ab) an organic solvent having a boiling point in the range from 60 to 160 °C and which is an aliphatic ketone, an alkanoic acid alkylester or hydroxyalkanoic acid alkylester or a cyclic ether, and

        ac) an organic solvent which has a boiling point in the range from 120 to 180 °C and which is a monoalkylether or an alkylester of propylene glycol or an alkyl ester of hydroxyalkanoic acid, with the proviso that (ac) is not an ether or ether ester of propylene glycol when (aa′) is present, and that (ac) is not an alkyl ester of hydroxyalkanoic acid when (ab) is such an ester,

    the quantitative proportion being selected such that a homogeneous mixture is obtained, and

    b) from 0.1 to 8 % by weight, relative to the total solvent mixture, of a solvent whose boiling point is higher than each individual boiling point of the solvents mentioned under (a) above and which is a lactone, a cyclic ester which is no lactone, a sulfoxide, a diglycolether or a lactam.

2. A coating solution as claimed in claim 1, wherein the boiling point of the solvent (b) is in the range from 160 to 250 °C.

3. A coating solution as claimed in claim 1, wherein the polar solvent (aa) comprises methanol.

4. A coating solution as claimed in claim 1, wherein the aliphatic ketone (ab) has from 3 to 6 carbon atoms.

5. A coating solution as claimed in claim 1, wherein the cyclic ether (ab) comprises tetrahydrofuran or dioxane.

6. A coating solution as claimed in claim 1, wherein the hydroxyalkanoic acid alkylester comprises a methylester or ethylester of lactic or glycolic acid.

7. A coating solution as claimed in claim 1, wherein the organic solvent (ac) comprises an alkylester or alkylether having from 1 to 2 carbon atoms in the alkyl group.

8. A coating solution as claimed in claim 1, wherein the binder is insoluble in water and soluble in aqueous-alkaline solutions.

9. A coating solution as claimed in claim 1, wherein the photohardenable compound is a diazonium salt polycondensation product.

10. A coating solution as claimed in claim 8, wherein the binder comprises a reaction product of an intramolecular anhydride of an organic polycarboxylic acid with a polymer containing hydroxyl groups and having no further functional groups capable of reaction with acid anhydrides.

11. A coating solution as claimed in claim 9, wherein the diazonium salt polycondensation product comprises recurring units $A-N_2X$ and B, which are linked by intermediate members, preferably methylene groups, which are derived from condensible carbonyl compounds, A being the radical of an aromatic diazonium compound which is capable of condensation with formaldehyde and B being the radical of a compound which is free of diazonium groups and is capable of condensation with formaldehyde, particularly of an aromatic amine, a phenol, phenol ether, aromatic thioether, an aromatic hydrocarbon, an aromatic heterocyclic compound or an organic acid amide.

12. A coating solution as claimed in claim 11, wherein the units $A-N_2X$ are derived from compounds of the general formula $(R^1-R^2-)_pR^3-N_2X$, in which

X           is the anion of the diazonium compound,
p           is an integer from 1 to 3,
$R^1$      aromatic radical which is capable of condensation with an active carbonyl compound in at least one position,
$R^3$      is a phenylene group, and
$R^2$      is a single bond or one of the groups:

$$-(CH_2)_q-NR^4-,$$
$$-O-(CH_2)_r-NR^4-,$$
$$-S-(CH_2)_r-NR^4-,$$
$$-S-CH_2CO-NR^4-,$$
$$-O-R^5-O-,$$
$$-O-,$$
$$-S-,$$

or

$$-CO-NR^4-,$$

whereby

q           is a number from 0 to 5,
r           is a number from 2 to 5,
$R^4$      is a hydrogen atom, an alkyl group having from 1 to 5 carbon atoms, an aralkyl group having from 7 to 12 carbon atoms or an aryl group having from 6 to 12 carbon atoms, and
$R^5$      is an arylene group having from 6 to 12 carbon atoms.

## Revendications

1. Solution d'enduction pour la fabrication d'un matériau d'enregistrement photosensible, qui contient, comme constituants principaux, un composé photodurcissable, un liant polymère et un mélange de solvants, caractérisée en ce que le mélange de solvants est un mélange à base de:
   a) un mélange de:
      aa) un solvant polaire de formule
                        R-OH,
      dans laquelle R est un groupe alkyle en $C_{1-3}$, ou
      aa') un éther monoalkylique ou un ester-éther alkylique du propylèneglycol,
      ab) un solvant organique de point d'ébullition 60 à 160°C, qui est une cétone aliphatique, un alcanoate ou hydroxyalcanoate d'alkyle ou un éther cyclique, et
      ac) un solvant organique de point d'ébullition 120 à 180°C, qui est un éther monoalkylique ou un ester-éther alkylique du propylèneglycol ou encore un hydroxyalcanoate d'alkyle, sous réserve que (ac) ne soit pas un éther ou un ester-éther du propyléneglycol quand (aa') est présent, et que (ac) ne soit pas un hydroxyalcanoate d'alkyle quand (ab) a cette définition, en des proportions relatives telles qu'un mélange homogène se forme, et
   b) 0,1 à 8 % en poids, par rapport au mélange total de solvants, d'un solvant dont le point d'ébullition est supérieur au point d'ébullition particulier de chaque solvant mentionné à propos de (a) et qui est une lactone, un ester cyclique non lactonique, un sulfoxyde, un éther de diglycol ou un lactame.

2. Solution d'enduction selon la revendication 1, caractérisée en ce que le point d'ébullition du solvant (b) est compris entre 160 et 250°C.

3. Solution d'enduction selon la revendication 1, caractérisée en ce que le solvant polaire (aa) est le méthanol.

4. Solution d'enduction selon la revendication 1, caractérisée en ce que la cétone aliphatique (ab) comporte 3 à 6 atomes de carbone.

5. Solution d'enduction selon la revendication 1, caractérisée en ce que l'éther cyclique (ab) est le tétrahydrofuranne ou le dioxanne.

6. Solution d'enduction selon la revendication 1, caractérisée en ce que l'hydroxyalcanoate d'alkyle est un ester méthylique ou éthylique de l'acide lactique ou de l'acide glycolique.

7. Solution d'enduction selon la revendication 1, caractérisée en ce que le solvant organique (ac) est un ester alkylique ou un éther alkylique comportant 1 à 2 atomes de carbone dans le groupe alkyle.

8. Solution d'enduction selon la revendication 1, caractérisée en ce que le liant est insoluble dans l'eau et soluble dans les solutions alcalines aqueuses.

9. Solution d'enduction selon la revendication 1, caractérisée en ce que le composé photodurcissable est un polycondensat de sel de diazonium.

10. Solution d'enduction selon la revendication 8, caractérisée en ce que le liant est un produit de la réaction d'un anhydride intramoléculaire d'un acide polycarboxylique organique avec un polymère comportant des groupes hydroxyle et qui ne contient pas d'autres groupes fonctionnels susceptibles de réagir avec des anhydrides d'acide.

11. Solution d'enduction selon la revendication 9, caractérisée en ce que le polycondensat de sel de diazonium se compose de motifs récurrents A-$N_2X$ et B, liés entre eux par des chaînons intermédiaires, de préférence des groupes méthylène, qui dérivent de composés carbonylés condensables, A étant le résidu d'un composé diazonium aromatique condensable avec du formaldéhyde et B étant le résidu d'un composé condensable avec du formaldéhyde et exempt de groupes diazonium, en particulier d'une aromatique, d'un phénol, d'un éther de phénol, d'un thioéther aromatique, d'un hydrocarbure aromatique, d'un composé hétérocyclique aromatique ou d'un amide organique.

12. Solution d'enduction selon la revendication 11, caractérisée en ce que les motifs A-$N_2X$ dérivent de composés de formule générale

$$(R^1\text{-}R^2\text{-})_p R^3\text{-}N_2X,$$

dans laquelle
- X représente l'anion du composé diazonium,
- p est un nombre entier de 1 à 3,
- $R^1$ représente un radical aromatique présentant au moins une position apte à la condensation avec un composé carbonylé actif,
- $R^3$ est un groupe phénylène,
- $R^2$ représente une liaison simple ou un des groupes:

$$-(CH_2)_q\text{-}NR^4\text{-},$$
$$-O\text{-}(CH_2)_r\text{-}NR^4\text{-},$$
$$-S\text{-}(CH_2)_r\text{-}NR^4\text{-},$$
$$-S\text{-}CH_2CO\text{-}NR^4\text{-},$$
$$-O\text{-}R^5\text{-}O\text{-},$$
$$-O\text{-},$$
$$-S\text{-}$$

ou

$$-CO\text{-}NR^4\text{-},$$

fragments dans lesquels:
- q est un nombre de 0 à 5,
- r est un nombre de 2 à 5,
- $R^4$ représente l'atome d'hydrogène, un groupe alkyle en $C_{1-5}$, un groupe aralkyle en $C_{7-12}$ ou un groupe aryle en $C_{6-12}$, et
- $R_5$ représente un groupe arylène en $C_{6-12}$.